(19) Europäisches Patentamt
European Patent Office
Office européen des brevets

(11) **EP 2 369 355 A1**

(12) **EUROPEAN PATENT APPLICATION**

(43) Date of publication:
**28.09.2011 Bulletin 2011/39**

(51) Int Cl.:
**G01R 31/28** $^{(2006.01)}$

(21) Application number: **10305185.0**

(22) Date of filing: **25.02.2010**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(71) Applicant: **Alcatel Lucent**
**75008 Paris (FR)**

(72) Inventors:
• **Witte, Martin**
**70435, Stuttgart (DE)**

• **Hildisch, Stefan**
**70825, Korntal-Münchingen (DE)**
• **Kienle, Roland**
**70499 Stuttgart (DE)**

(74) Representative: **Wetzel, Emmanuelle**
**Alcatel-Lucent Deutschland AG**
**Intellectual Property & Corporate Standards**
**Lorenzstrasse 10**
**70435 Stuttgart (DE)**

(54) **Method for measuring an oscillator and device thereof**

(57)　The invention relates to a method for measuring an oscillator (OSC) and comprises the steps of measuring a first parameter related to a voltage (SUP_V) applied to the oscillator (OSC) as a function of a frequency of the voltage (SUP_V), and measuring a second parameter of an output signal (OS_OSC) of the oscillator (OSC) as a function of the frequency of the voltage (SUP_V), wherein the method further comprises the step of determining from the measured first parameter related to the voltage (SUP_V) and from the measured second parameter of the output signal (OS_OSC) a third parameter related to a frequency shift of the oscillator (OSC) as a function of the frequency of the voltage (SUP_V). The invention further relates to a device (MD) for measuring the oscillator (OSC).

FIG. 1

EP 2 369 355 A1

**Description**

**FIELD OF THE INVENTION**

The invention relates to a method for measuring an oscillator according to the preamble of claim 1 and to a device for measuring an oscillator according to the preamble of claim 13.

**BACKGROUND**

Oscillators such as voltage-controlled oscillators (VCO = voltage-controlled oscillator) are used for example in transmitters or receivers of a radio communication system to generate a controllable oscillation frequency for selecting via a mixing process a transmission frequency at the transmitter or for selecting via a mixing process a receiving frequency at the receiver. One of the characteristic parameters of the oscillators is pushing. Pushing describes a sensitivity of an output frequency of the oscillator according to a variable DC supply voltage (DC = direct current) with fixed DC tuning voltage. A tuning sensitivity describes a further sensitivity of the output frequency of the oscillator according to a variable DC tuning voltage with fixed DC supply voltage.

Pushing can be measured by a signal source analyzer, which provides a low-noise source for the DC supply voltage and the DC tuning voltage. For such a measurement, the DC supply voltage or the DC tuning voltage is increased stepwise and the output frequency of the oscillator is measured in a quasi-static condition for specific levels of the DC supply voltage or the DC tuning voltage. Specifications of oscillators usually provide a pushing characteristic for a non-locked free-running oscillator.

A quality of the output frequency of the oscillator in terms of phase noise and spurious oscillations strongly depends on a quality of the DC supply voltage or the DC tuning voltage in terms of contained noise components. Therefore, specifications of voltage supplies often provide a characteristic curve with a voltage noise spectral density as a function of frequency.

The quality of the output frequency of the oscillator further depends on a quality of the oscillator itself, on a loop filter, and on a phase-locked loop integrated circuit mainly in terms of phase noise performance.

When the output frequency characteristic of a synthesized oscillator is measured and a phase noise or spurious oscillations above allowed specification limits (given for example by radio communication standards or by legal regulations) are observed, it is not possible to identify immediately, which component of the synthesized oscillator is accountable for exceeding the allowed specification limits.

**SUMMARY**

The way of measuring the oscillator effects identification of phase noise sources or spurious oscillation sources and effects specification requirements of voltage supplies or phase-locked loop oscillators. Therefore, it is a main object of the invention to provide an improved measurement method and an improved device executing the improved measurement method.

The object is achieved by a method for measuring an oscillator, wherein the method comprises the steps of measuring a first parameter related to a voltage applied to the oscillator as a function of a frequency of the voltage, and measuring a second parameter of an output signet of the oscillator as a function of the frequency of the voltage, wherein the method further comprises the step of determining from the measured first parameter related to the voltage and from the measured second parameter of the output signal a third parameter related to a frequency shift of the oscillator as a function of the frequency of the voltage.

The object is further achieved by a device for measuring an oscillator.

The oscillator may be for example a VCO, a VCXO (VCXO = voltage controlled crystal oscillator) or an OXCO (OXCO = oven controlled crystal oscillator). The first parameter may be for example a supply voltage noise density, the second parameter may be for example a phase noise density or an amplitude noise density, and the third parameter may be for example a voltage dependent frequency shift of the oscillator.

The invention provides a first benefit of measuring an influence of the first parameter related to the voltage of a voltage supply on the third parameter related to the frequency shift of the oscillator as a function of the frequency of the voltage. The invention provides a second benefit of providing a characteristic curve with an upper limit for example for a pushing function, which is usually a voltage dependent frequency shift of the oscillator as a function of the frequency of the voltage. The invention provides a third benefit of providing a characteristic curve with an upper limit for example for a voltage noise density of the voltage of a voltage source. This can be used in module specification and modeling for suppliers of voltage sources or for suppliers of modules comprising the oscillator and the voltage source. This can also be used for system specification by OEMs (OEM = original equipment manufacturer) involved in phase-locked loop oscillator and synthesizer design. A system designer of an OEM is for example able to select a voltage supply type with a specification below the upper limit of the voltage noise density. Furthermore, the invention can be used by measurement equipment manufacturers in measurement devices such as signal source analyzers, digital storage oscilloscopes, digital sampling oscilloscopes, or mixed-signal oscilloscopes with inputs for analogue and digital channels, or by PC hardware and software companies in PC-based oscilloscopes.

In two embodiments of the invention, the voltage may be a supply voltage of the oscillator or a tuning voltage of the oscillator. These embodiments offer an advantage of measuring an influence of the supply voltage or the tuning voltage on the third parameter related to the frequency shift of the oscillator. This allows on the one hand for providing characteristic curves with an upper limit for a pushing function dependent on frequency components of the supply voltage and/or the tuning voltage and on the other hand of providing characteristic curves with an upper limit for example according to the voltage noise density of a voltage supply for the supply voltage and/or the tuning voltage.

In a further embodiment of the invention, the voltage comprises at least one predefined AC component (AC = alternating current).

The further embodiment offers a first benefit of measuring and testing an influence of the at least one predefined AC component of the voltage on the third parameter related to the frequency shift of the oscillator. This allows to precisely determine an upper voltage limit for the at least one predefined AC component to comply for example with the upper limit of the supply voltage noise density.

Preferably, a voltage level of the at least one predefined AC component is above a predefined threshold. The predefined threshold may be selected in such a way, that a background noise of other noise sources such as the oscillator itself, the loop filter of the phase-locked loop, and the phase-locked loop integrated circuit are beaten to a large extend by a much larger voltage dependent noise.

In a preferred embodiment of the invention, the at least one predefined AC component is located in a first predefined frequency range, the voltage comprises at least one further predefined AC component in at least one second predefined frequency range, the determining step is performed for the first predefined frequency range with a voltage level of the voltage within a first predefined voltage level range and is performed for the second predefined frequency range with a voltage level of the voltage within at least one second predefined voltage level range above the first predefined voltage level range.

This provides an advantage of measuring and testing the influence of the at least one predefined AC component and the at least one further predefined AC component of the voltage at two or more voltage levels. Even if the voltage level of the at least one predefined AC component is equal for a specific frequency range, the influence on the second parameter of the output signal of the oscillator as the function of the frequency of the voltage and the influence on the third parameter related to the frequency shift of the oscillator as a function of the frequency of the voltage can be different. The difference may be so large, that a same voltage level of the at least one predefined AC component at the first predefined frequency range and the at least one further predefined AC component at the at least one second predefined frequency range may drive the measured second parameter of the output signal of the oscillator or the determined third parameter related to the frequency shift of the oscillator into saturation within the first predefined frequency range and not into saturation within the at least one second predefined frequency range. Therefore, the preferred embodiment of the invention can be used to adapt the first predefined voltage level range within the first predefined frequency range and to adapt the at least one second predefined voltage level range within the at least one second predefined frequency range for avoiding a saturation in the first predefined frequency range and the at least one second predefined frequency range.

In a further preferred embodiment of the invention, the determining step is performed for a voltage level of the voltage within a first predefined voltage level range and for the voltage level of the voltage within at least one second predefined voltage level range above the first predefined voltage level range, wherein a total noise of the second parameter of the output signal of the oscillator comprises a background noise and a voltage related noise, and wherein the method further comprises the step of determining the background noise by a differential measurement for the first predefined voltage level range and for the second predefined voltage level range.

This provides a benefit of determining the background noise such as a phase noise or amplitude noise for example of the oscillator itself, of the loop filter, and of the PLL IC.

In an even further embodiment of the invention, the at least one predefined AC component may have a voltage level above a predefined AC threshold within a predefined frequency range.

This offers a possibility of applying a voltage to the oscillator with AC components covering continuously the predefined frequency range and with voltage levels above the predefined AC threshold. Thereby, the influence of the voltage on the output signal of the oscillator can be measured according to a specific frequency range.

In an even further preferred embodiment of the invention, the at least one predefined AC component has a voltage level above a first predefined AC threshold at a predefined frequency, and the voltage within a predefined frequency range around the predefined frequency has a voltage level below a second predefined AC threshold.

This provides a benefit of applying a voltage to the oscillator with the one or several predefined AC components above the first predefined AC threshold at a specific frequency and with a voltage level of the voltage below the second predefined AC threshold around the specific frequency. Thereby, the influence of the voltage having a single specific spurious oscillation or single specific test tone on the output signal of the oscillator can be measured according to the specific frequency.

According to a further embodiment of the invention, the voltage further comprises at least one further predefined AC component, the at least one further predefined AC component has a voltage level above the first predefined AC threshold at one or several further predefined frequencies, and the one or several further predefined frequencies are separated from the predefined frequency by the predefined frequency range.

This provides a first benefit of applying a voltage to the oscillator with the one or several predefined AC components and the one or several further predefined AC components above the first predefined AC threshold at two or more specific frequencies and with the voltage level of the voltage below the second predefined AC threshold between the specific frequencies. Thereby, the influence of the voltage having two or more specific spurious oscillations or two or more specific test tones on the output signal of the oscillator can be measured according to the two or more specific frequencies.

According to two further embodiments of the invention, the at least one predefined AC component may comprise an arbitrary waveform or a noise signal. This allows for a large flexibility in measuring the oscillator with a large variety of different signal forms of the predefined AC components of the voltage. Thereby, the output signal of the oscillator can be analyzed for most frequently occurring signal forms of AC components, which may be undesirably included in a voltage of a supply voltage or a tuning voltage.

In a further preferred embodiment of the invention, the first parameter related to the voyage is measured at an input of the oscillator for the voltage. Thereby, the first parameter related to the voltage can be measured with a higher accuracy, because the first parameter related to the voltage directly measured at a source of the voltage might be different than measured at the input of the oscillator.

In an even further preferred embodiment of the invention, the device for measuring the oscillator further comprises means for generating the voltage with the at least one predefined AC component.

This allows to reduce devices of a measurement setup because generating the voltage with the at least one predefined AC component and determining the third parameter related to the frequency shift of the oscillator can be provided with a same device. This further allows performing automatically repeated measurements with voltages having different predefined AC components.

Further advantageous features of the invention are defined and are described in the following detailed description of the invention.

## BRIEF DESCRIPTION OF THE FIGURES

The embodiments of the invention will become apparent in the following detailed description and will be illustrated by accompanying figures given by way of non-limiting illustrations.

Figure 1 shows schematically a block diagram of a measurement setup for measuring an oscillator according to an embodiment of the invention.

Figure 2 shows schematically a block diagram of a method for measuring an oscillator according to further embodiments of the invention.

Figure 3 shows five characteristic curves of a phase noise density of an oscillator, of a phase noise density of a loop filter, of a phase noise density of a crystal oscillator, of a phase noise density of a phase-locked loop integrated circuit, and of a background phase noise density as a sum of the phase noise density of the oscillator, the loop filter, the crystal oscillator, and the phase-locked loop integrated circuit

Figure 4 shows three characteristic curves of a voltage noise density, a phase noise density, and a pushing function according to a preferred embodiment of the invention.

Figure 5 shows further three characteristic curves of a voltage noise density, a phase noise density, and a pushing function according to a further preferred embodiment of the invention.

## DESCRIPTION OF THE EMBODIMENTS

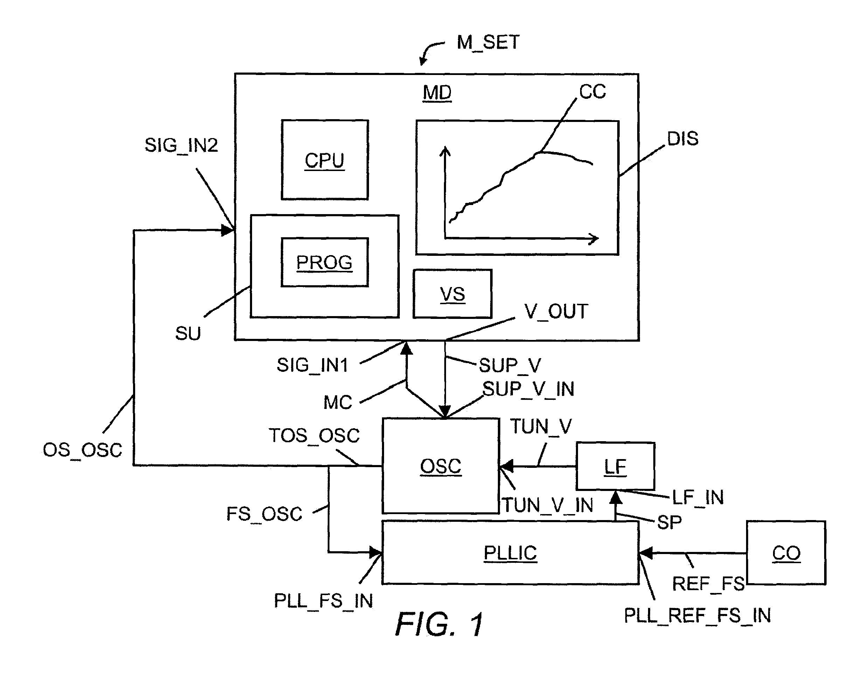

Referring to Figure 1a measurement setup M_SET according to an embodiment of the invention is shown.

The measurement setup M_SET may comprise a measurement device MD, an oscillator OSC, a phase-locked loop integrated circuit PLLIC, a loop filter LF, and a crystal oscillator CO, if the oscillator OSC is operated in a locked mode (as shown in Figure 1).

In an alternative, the measurement setup M_SET does not comprise the phase-locked loop integrated circuit PLLIC, the loop filter LF, and the crystal oscillator CO, if the oscillator OSC may be operated in a free running mode.

The measurement device MD may be for example a signal source analyzer, a digital storage oscilloscope, a digital sampling oscilloscope, a mixed-signal oscilloscope with inputs for analogue and digital channels, or a PC-based oscilloscope (PC = personal computer).

The measurement device MD may comprise a first signal input SIG_IN1, a second signal input SIG_IN2, a voltage output V_OUT, a central processing unit CPU, a storage unit SU, a voltage source VS, and a display DIS.

In an alternative, the voltage output V_OUT and the voltage source VS are provided by a separate voltage device.

The voltage source VS may generate a voltage SUP_V and the voltage SUP_V is output by the voltage output V_OUT of the measurement device MD.

The voltage SUP_V may be for example a supply voltage of the oscillator OSC as shown in Figure 1. In that case, the voltage SUP_V is applied to a supply voltage input SUP_V_IN of the oscillator OSC.

In an alternative, the voltage source VS may generate additionally a tuning voltage for the oscillator OSC and the tuning voltage may be applied to a tuning voltage input TUN_V_IN of the oscillator OSC, if the oscillator OSC may be measured in the free running mode (not shown).

In a further alternative, the supply voltage of the oscillator OSC may be generated by the separate voltage device and the voltage source VS of the measurement device MD may only generate the tuning voltage of the oscillator OSC.

Preferably, the voltage SUP_V provided by the measurement device MD comprises one or several predefined AC components for measuring and analyzing an influence of the one or several predefined AC components on an output signal OS_OSC of the oscillator OSC.

A parameter related to the voltage SUP_V such as a voltage noise density may be measured preferably at the supply voltage input SUP_V_IN or at the tuning voltage input TUN_V_IN of the oscillator OSC via a measurement connection MC between the supply voltage input SUP_VIN or the tuning voltage input TUN_V_IN of the oscillator OSC and the first signal input SIC_IN1 of the measurement device MD.

Preferably, the voltage noise density of the voltage SUP_V is measured as a function of a frequency of the voltage SUP_V.

The oscillator OSC as shown exemplarily in Figure 1 is operated in the locked mode by applying a part of a total output signal TOS_OSC of the oscillator OSC as a feedback signal FS_OSC to a feedback input PLL_FS_IN of the phase-locked loop integrated circuit PLLIC. The oscillator OSC may be for example a VCO, a VCXO, or an OCXO. The total output signal TOS_OSC of the oscillator OSC may be split into the feedback signal FS_OSC and the output signal OS_OSC for example by using a coupler.

A reference frequency signal REF_FS is provided by the crystal oscillator CO and is applied to a reference input PLL_REF_FS_IN of the phase-locked loop integrated circuit PLLIC. The crystal oscillator CO may be for example a TCXO (TCXO = Temperature Compensated Crystal Oscillator). Within the phase-locked loop integrated circuit PLLIC, the feedback signal FS_OSC and the reference frequency signal REF_FS are frequency divided by frequency dividers. A phase comparator of the phase-locked loop integrated circuit PLLIC compares phases of the frequency divided feedback signal FS_OSC and the frequency divided reference frequency signal REF_FS and usually outputs signal pulses SP, which are applied to an input LF_IN of the loop filter LF. A pulse width and a polarity of the signal pulses SP is a measure of a phase difference between the frequency divided feedback signal FS_OSC and the frequency divided reference frequency signal REF_FS. The loop filter LF is usually a low pass filter to generate from the signal pulses SP a tuning voltage TUN_V. The tuning voltage TUN_V is applied to the tuning voltage input TUN_V_IN of the oscillator OSC. The tuning voltage TUN_V is used within the oscillator OSC to adjust a frequency of the output signal OS_OSC of the oscillator OSC. The output signal OS_OSC of the oscillator OSC is applied to the second signal input SIG_IN2 of the measurement device MD for measuring one or several parameters of the output signal OS_OSC of the oscillator OSC such as a phase noise density and/or an amplitude noise density preferably as a function of the frequency of the voltage SUP_V.

The storage unit SU may be foreseen for storing a computer readable program PROG. The computer readable program PROG of the measurement device MD may be used for determine from the measured parameter related to the voltage SUP_V and from the measured parameter of the output signal OS_OSC of the oscillator OSC a parameter related to a frequency shift of the oscillator OSC preferably as a function of the frequency of the voltage SUP_V.

The central processing unit CPU may be foreseen for executing the computer readable program PROG.

The display DIS may provide a characteristic curve CC of the determined parameter related to the frequency shift of the oscillator OSC preferably as a function of the frequency of the voltage SUP_V.

In an alternative, the measurement device MD may comprise instead of the display DIS or in addition to the display DIS an output port for an output signal providing data of the determined parameter related to the frequency shift of the oscillator OSC preferably as a function of the frequency of the voltage SUP_V. The data may be used to print the characteristic curve CC of the determined parameter related to the frequency shift of the oscillator OSC by a printer or to provide the data to a computer for further processing of the determined parameter related to the frequency shift of the oscillator OSC.

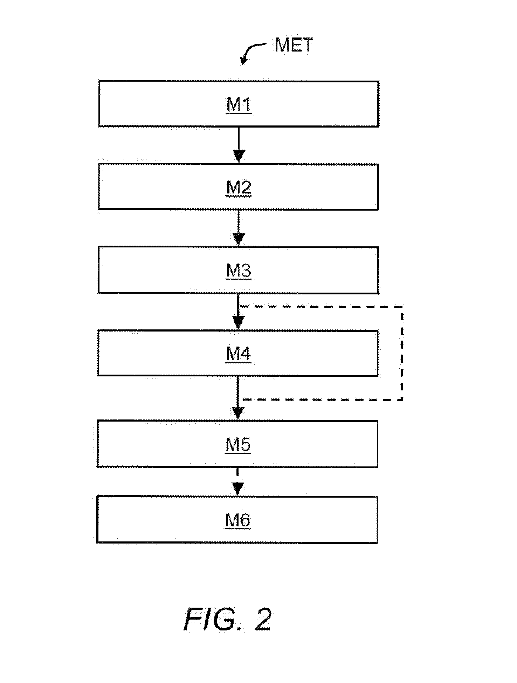

Referring to Figure 2, a block diagram of a method MET for measuring the oscillator OSC is shown.

The sequence and the number of the steps for performing the method MET is not critical, and as can be understood by those skilled in the art, that the sequence and the number of the steps may vary without departing from the scope of the invention.

In a first step M1, the voltage is applied to the oscillator OSC via the voltage supply VS. If the voltage SUP_V is the supply voltage of the oscillator OSC, the supply voltage is applied preferably by the voltage source VS of the measurement device MD to the supply voltage input SUP_V_IN of the locked oscillator OSC (as shown in Figure 1). If the voltage SUP_V is the tuning voltage of the oscillator OSC, the tuning voltage is applied preferably by the voltage source VS of the measurement device MD to the tuning voltage input TUN_V_IN of the free-running oscillator OSC.

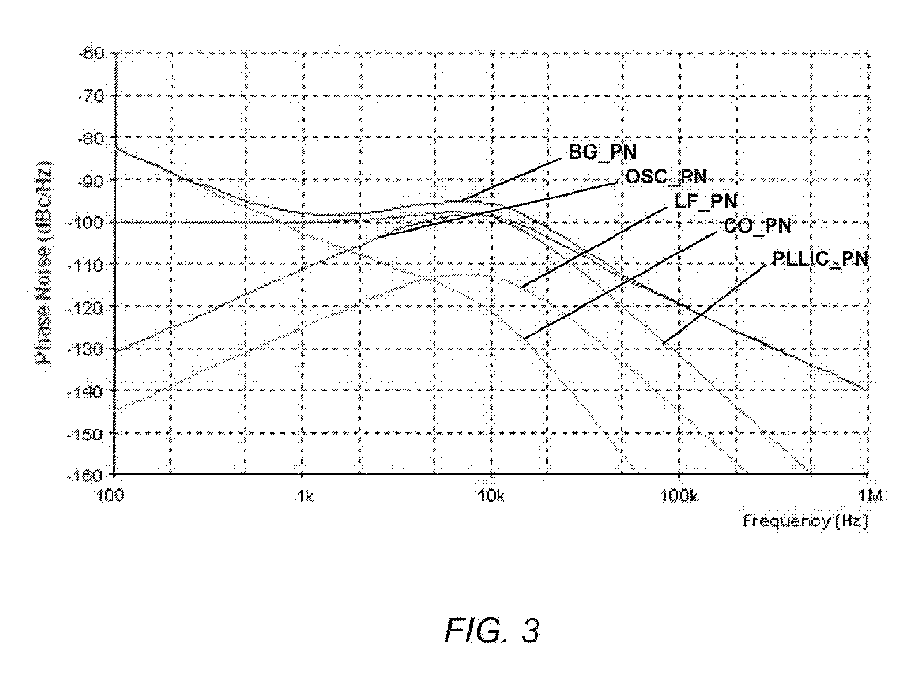

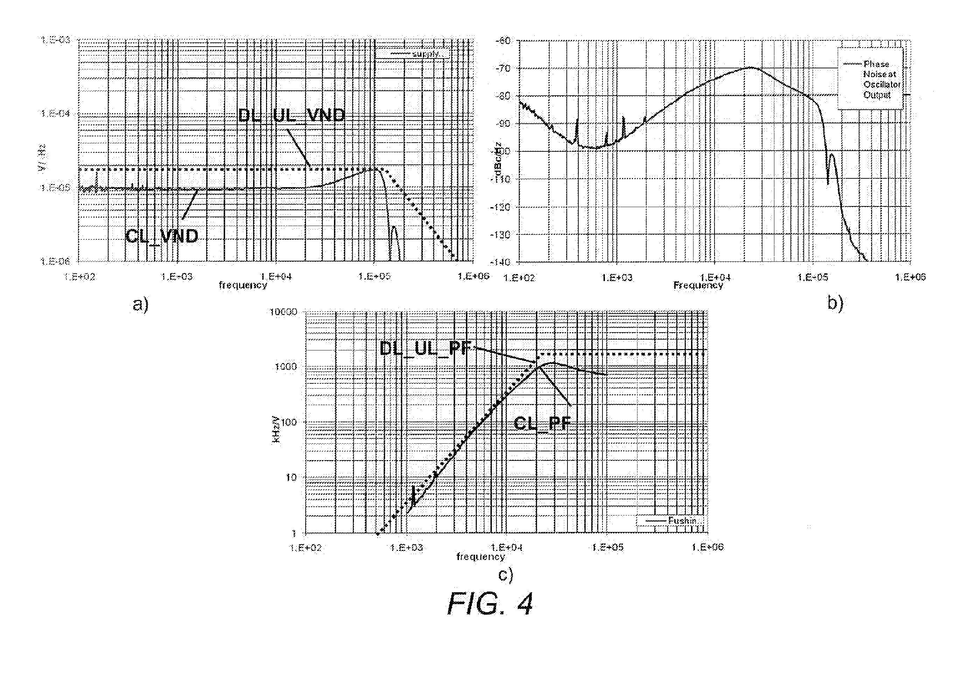

In a further step M2, the parameter related to the voltage applied to the oscillator is measured preferably as the function of the frequency of the voltage via the first signal input SIG_IN1 by the measurement device MD (as shown in Figure 3a and 4a).

In a next step M3, the one or several parameters of the output signal OS_OSC of the oscillator OSC such as the phase noise density and/or the amplitude noise density are measured preferably as a function of the frequency of the voltage via the second signal input SIG_IN2 by the measurement device MD (as shown in Figure 3b and 4b).

In a further step M4, the parameter related to the frequency shift of the oscillator OSC such as the voltage dependent frequency shift is determined preferably by the central processing unit CPU and the computer readable program PROG preferably as a function of the frequency of the voltage (as shown in Figure 3c and 4c).

The voltage dependent frequency shift of the oscillator OSC as a sensitivity of the oscillator OSC regarding to the supply voltage is called pushing. A dependency of the pushing on a frequency f is given by the following pushing function:

$$K\_pushing(f) = SQRT(2 \bullet L(f)) \bullet f / V\_vvc(f)$$

with the following meanings:

| | | |
|---|---|---|
| f | : | frequency of AC component (of the voltage) in Hz |
| K_pushing(f) | : | pushing function in Hz / V |
| L(f) | : | relative SSB phase noise power density (SSB = single sideband) or relative SSB amplitude noise power density in 1 / Hz |
| Y_vvc(f) | : | voltage noise density in V / SQRT(Hz) |
| SQRT(XYZ) | : | square root of XYZ |

Such an equation is given for example in Johan van der Tang et al. "HighFrequency Oscillator Design for Integrated Transceivers", Kluwer Academic Publishers, second edition, page 84.

Usually, the phase noise density or the amplitude noise density are measured with a dB scale (dB = decibel). Therefore, in a first sub-step, the central processing unit CPU and the computer readable program PROG may be used to delogarithmize the measured phase noise density or the measured amplitude noise density to obtain the function L(f). In a next sub-step, the central processing unit CPU and the computer readable program PROG may be used to calculate the pushing function K_pushing(f) for one or several predefined AC components of the voltage within a predefined frequency range by using the above mentioned equation.

In a preferred alternative, the voltage may comprises the one or several predefined AC components in a first predefined frequency range with a voltage level of the one or several predefined AC components within a first predefined voltage level range for a first time performing the step M4. In one or several second times performing the step M4 repeatedly, the voltage may comprise one or several further predefined AC components in one or several second predefined frequency ranges with a voltage level of the one or several further predefined AC components within one or several second predefined voltage level ranges above the first predefined voltage level range. Advantages of the preferred alternative are given in the summary section.

A total phase noise or total amplitude noise of the output signal OS_OSC of the oscillator OSC is given by a background noise and a voltage related noise. The voltage related noise is based on the predefined AC components of the voltage SUP_V.

A background phase noise density BG_PN results for example from a phase noise density OSC_PN of the oscillator OSC itself, from a phase noise density LF_PN of the loop filter LF, from a phase noise density CO_PN of the crystal oscillator CO, and/or from a phase noise density PLLIC_PN of the phase-locked loop integrated circuit PLLIC as shown in Figure 3. The characteristic curves of the phase noise densities shown in Figure 3 have been simulated by a simulation tool.

In a further preferred alternative, in a first time performing the determining step M4 a voltage level of the one or several predefined AC components is within a first predefined voltage level range. In one or several second times performing the step M4 repeatedly, the voltage level of the one or several predefined AC components is within one or several second predefined voltage level ranges and is different to the first predefined voltage level range for example by a predefined factor a.

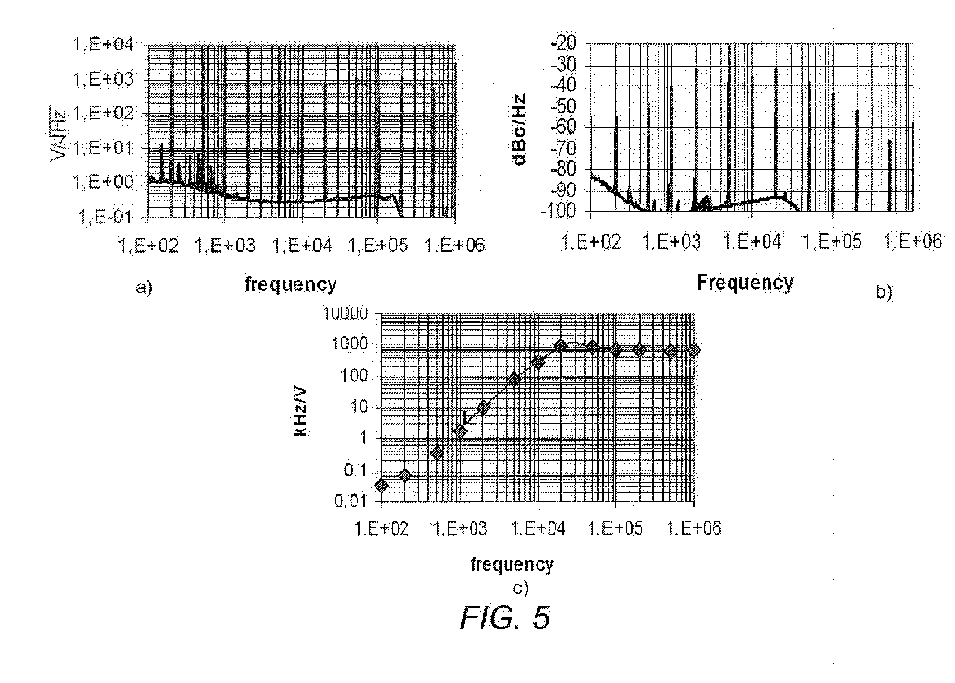

In a next step M5, the determined voltage dependent frequency shift of the oscillator OSC may be output for example on the display DIS of the measurement device MD by using characteristic curves as shown in Figure 4c) or Figure 5 c).

In a further step M6, the background noise of the phase noise or the amplitude noise may be determined by a differential measurement using the first predefined voltage level range and the one or several second predefined voltage level ranges.

A result of the first time performing the step M4 may be:

$$TN1(f) = BGN(f) + VRN(f)$$

with the following meanings:

| | | |
|---|---|---|
| TN1 (f) | : | total phase or amplitude noise density for the first predefined voltage level range |
| BGN(f) | : | background phase noise or amplitude noise density |
| VRN(f) | : | voltage related phase noise or amplitude noise density for the first predefined voltage level range |

A result of the second time performing the step M4 may be:

$$TN2(f) = BGN(f) + a \cdot VRN(f)$$

with the following meanings

| | | |
|---|---|---|
| TN2(f) | : | total phase or amplitude noise density for the second predefined voltage level range |
| a | : | factor between the first predefined voltage level range and the second predefined voltage level range |

and by assuming that the voltage related noise linearly increases with the predefined voltage level of the predefined voltage range.

The background phase noise or amplitude noise density can be obtained by using the following equations:

$$TN2(f) - TN1(f) = (a - 1) \cdot VRN1(f)$$
$$==> VRN1(f) = (TN2(f) - TN1(f)) / (a - 1)$$

$$TN1(f) + TN2(f) = 2 \cdot BGN(f) + (1 + a) \cdot VRN1(f)$$
$$==> BGN(f) = (a-1) \cdot (TN1(f) + TN2(f)) - (1+a) \cdot (TN2(f) - TN1(f)) / (2 \cdot (a-1))$$

Figure 4 shows three characteristic curves of a voltage noise density, a phase noise density, and a pushing function according to a preferred embodiment of the invention.

In Figure 4 a) the measured voltage noise density of the voltage SUP_V of the voltage source VS is shown in units V/SQRT(Hz) by a continuous line CL_VND as a function of the frequency f of AC components of the voltage SUP_V in unit Hz.

Preferably, the one or several predefined AC components of the voltage SUP_V may be above a predefined AC threshold within a predefined frequency range. According to Figure 4 a), the predefined AC threshold is for example 9.E-06 V/SQRT(Hz) and the predefined frequency range is for example from 1.E+02 Hz to 1.E+05 Hz.

Figure 4 a) further shows a dotted line DL_UL_VND with an upper limit for the voltage noise density for a predefined output voltage of the voltage source VS. A system designer may use the dotted line DL_UL_VND with the upper limit for the voltage noise density, when selecting the voltage source VS for a transmitter according to specification limits of a total noise density of radio signals given for example by radio communication standards or by legal regulations.

The upper limit for the voltage noise density may be set by the system designer, when the background noise density is given by selected components for the oscillator OSC, the phase-locked loop integrated circuit PLLIC, and the loop filter LF to stay below the specification limits for the total noise density.

In Figure 4 b) the measured phase noise density of the output signal OS_OSC of the oscillator OSC is shown in units dBc/Hz (dBc = decibels relative to a carrier) by a continuous line as a function of the frequency f of AC components of the voltage SUP_V in unit Hz.

In Figure 4 c) the determined voltage dependent frequency shift of the output signal OS_OSC of the oscillator OSC is shown in units kHz/V by a continuous line CL_PF as a function of the frequency f of AC components of the voltage SUP_V in unit Hz.

Figure 4 c) further shows a dotted line DL_UL_PF with an upper limit for the voltage dependent frequency shift of the oscillator OSC. A system designer may use the dotted line DL_UL_PF with the upper limit for the voltage dependent frequency shift, when selecting for a transmitter a system comprising the voltage source VS, the oscillator OSC, the loop filter LF, and the phase-locked loop integrated circuit PLLIC according to specification limits of the total noise density of the radio signals.

Figure 5 shows further three characteristic curves of a voltage noise density, a phase noise density, and a pushing function according to a further preferred embodiment of the invention.

In Figure 5 a) the measured voltage noise density of the voltage SUP_V of the voltage source VS is shown in units V/SQRT(Hz) as a function of the frequency f of AC components of the voltage SUP_V in unit Hz. Contrary to the measured voltage noise density shown in Figure 4 a) with a relatively small dynamic range, the measured voltage noise density shown in Figure 5a) has a spike-like or tone-like characteristic in a frequency domain or a ripple-like characteristic in a time domain with a relatively large dynamic range.

Preferably, the one or several predefined AC components of the voltage SUP_V may have a voltage level above a first predefined AC threshold at a predefined frequency and the voltage SUP_V within a predefined frequency range around the predefined frequency has a voltage level below a second predefined AC threshold. According to Figure 5 a), the first predefined AC threshold is for example 1.E+03 V/SQRT(Hz), the predefined frequency is for example 2.E+03 Hz, the predefined frequency range is for example from 1.5E+03 Hz to 3.E+03 Hz, and the second predefined AC threshold is for example 1.E+00 V/SQRT(Hz). This allows providing a high dynamic range.

In a further alternative as shown in Figure 5 a), the voltage SUP_V further comprises one or several further predefined AC components, the one or several further predefined AC components have the voltage level above the first predefined AC threshold at one or several further predefined frequencies, and the one or several further predefined frequencies are separated from the predefined frequency by the predefined frequency range. According to Figure 5 a), the further predefined frequencies are for example 1.E+03 Hz and 5.E+03 Hz. This allows providing a high dynamic range for a wide frequency range.

In Figure 5 b) the measured phase noise density of the output signal OS_OSC of the oscillator OSC is shown in units dBc/Hz as a function of the frequency f of AC components of the voltage SUP_V in unit Hz.

In Figure 5 c) the determined voltage dependent frequency shift of the output signal OS_OSC of the oscillator OSC is shown in units kHz/V with rhombs located at the frequency locations of the predefined AC components with voltage levels above the first predefined AC threshold as a function of the frequency f of AC components of the voltage SUP_V in unit Hz.

**Claims**

1. A method (MET) for measuring an oscillator (OSC), said method (MET) comprising the steps of:

  - measuring (M2) a first parameter related to a voltage (SUP_V) applied to said oscillator (OSC) as a function of a frequency of said voltage (SUP_V), and
  - measuring (M3) a second parameter of an output signal (OS_OSC) of said oscillator (OSC) as a function of said frequency of said voltage (SUP_V),

**characterized in that** said method (MET) further comprising the step of determining (M4) from said measured parameter related to said voltage (SUP_V) and from said measured parameter of said output signal (OS_OSC) a third parameter related to a frequency shift of said oscillator (OSC) as a function of said frequency of said voltage (SUP_V).

2. Method (MET) according to claim 1, wherein said voltage (SUP_V) is a supply voltage of said oscillator (OSC) or a tuning voltage of said oscillator (OSC).

3. Method (MET) according to any of the preceding claims, wherein said voltage (SUP_V) comprises at least one predefined AC component.

4. Method (MET) according to claim 3, wherein said at least one predefined AC component is located in a first predefined frequency range, wherein said voltage (SUP_V) comprises at least one further predefined AC component in at least one second predefined frequency range, wherein said determining step (M4) is performed for said first predefined frequency range with a voltage level of said voltage (SUP_V) within a first predefined voltage level range and is performed for said second predefined frequency range with a voltage level of said voltage (SUP_V) within at least one second predefined voltage level range above said first predefined voltage level range.

5. Method (MET) according to claim 3, wherein said determining step (M4) is performed for a voltage level of said voltage (SUP_V) within a first predefined voltage level range and for said voltage level of said voltage (SUP_V) within at least one second predefined voltage level range above said first predefined voltage level range, wherein a total noise of said second parameter of said output signal (OS_OSC) of said oscillator (OSC) comprises a background noise and a voltage related noise, and wherein said method (MET) further comprises the step of determining (M6) said background noise by a differential measurement for said first predefined voltage level range and for said second predefined voltage level range.

6. Method (MET) according to any of the claims 3, 4, 5, wherein said at least one predefined AC component has a voltage level above a predefined AC threshold within a predefined frequency range.

7. Method (MET) according to any of the claims 3, 4, 5, wherein said at least one predefined AC component has a voltage level above a first predefined AC threshold at a predefined frequency, and wherein said voltage within a predefined frequency range around said predefined frequency has a voltage level below a second predefined AC threshold.

8. Method (MET) according to claim 7, wherein said voltage (SUP_V) further comprises at least one further predefined AC component, wherein said at least one further predefined AC component has a voltage level above said first predefined AC threshold at at least one further predefined frequency, and wherein said at least one further predefined frequency is separated from said predefined frequency by said predefined frequency range.

9. Method (MET) according to any of the claims 3, 4, 5, 6, 7, 8, wherein said at least one predefined AC component comprises an arbitrary waveform.

10. Method (MET) according to any of the claims 3, 4, 5, 6, 7, 8, wherein said at least one predefined AC component comprises a noise signal.

11. Method (MET) according to any of the preceding claims, wherein said first parameter related to said voltage (SUP_V) is measured at an input of said oscillator (OSC) for said voltage (SUP_V).

12. Method (MET) according to any of the preceding claims, wherein said first parameter is a voltage noise density, wherein said second parameter is a phase noise density, and wherein said third parameter is a voltage dependent frequency shift of said oscillator (OSC).

13. A device (MD) for measuring an oscillator (OSC), said device (MD) comprising:

- means for measuring a first parameter related to a voltage (SUP_V) applied to said oscillator (OSC) as a function of a frequency of said voltage (SUP_V), and
- means for measuring a second parameter of an output signal (OS_OSC) of said oscillator (OSC) as a function of said frequency of said voltage (SUP_V),

**characterized in that** said device (MD) further comprising means for determining from said measured first parameter related to said voltage (SUP_V) and from said measured second parameter of said output signal (OS_OSC) a third parameter related to a frequency shift of said oscillator (OSC) as a function of said frequency of said voltage (SUP_V).

14. Device (MD) according to claim 13, wherein said device (MD) further comprises means (VS) for generating said voltage (SUP_V) with at least one predefined AC component.

FIG. 1

EP 2 369 355 A1

MET

```
┌─────────────────────────────────┐
│              M1                 │
└─────────────────────────────────┘
                │
                ▼
┌─────────────────────────────────┐
│              M2                 │
└─────────────────────────────────┘
                │
                ▼
┌─────────────────────────────────┐
│              M3                 │
└─────────────────────────────────┘
                │
                ▼
┌─────────────────────────────────┐
│              M4                 │
└─────────────────────────────────┘
                │
                ▼
┌─────────────────────────────────┐
│              M5                 │
└─────────────────────────────────┘
                │
                ▼
┌─────────────────────────────────┐
│              M6                 │
└─────────────────────────────────┘
```

*FIG. 2*

*FIG. 3*

a)

b)

c)

*FIG. 4*

a)      frequency

b)      Frequency

c)      frequency

*FIG. 5*

Europäisches
Patentamt

European
Patent Office

Office européen
des brevets

## EUROPEAN SEARCH REPORT

Application Number

EP 10 30 5185

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | XUEJIN WANG ET AL: "Systematic Design of Supply Regulated LC -Tank Voltage-Controlled Oscillators" IEEE TRANSACTIONS ON CIRCUITS AND SYSTEMS I: REGULAR PAPERS, IEEE, US LNKD- DOI:10.1109/TCSI.2008.918004, vol. 55, no. 7, 1 August 2008 (2008-08-01) , pages 1834-1844, XP011224927 ISSN: 1549-8328 * abstract; figures 1,3,8-12,15-17 * * page 1834, left-hand column, paragraph 1 - page 1836, left-hand column, paragraph 1 * * page 1841, left-hand column, paragraph 2 - page 1843, right-hand column, paragraph 1 * ----- | 1-14 | INV. G01R31/28 |
| X | ANONYMOUS: "Agilent E5052B Signal Source Analyzer; Boosting PLL Design Efficiency" 21 November 2008 (2008-11-21), pages 1-30, XP002598724 Retrieved from the Internet: URL:http://cp.literature.agilent.com/litwe b/pdf/5989-9848EN.pdf [retrieved on 2010-08-27] | 13,14 | |
| A | * page 3, paragraph 2 - page 12; figures 13,14 * ----- | 1-12 | TECHNICAL FIELDS SEARCHED (IPC) G01R H03L |

The present search report has been drawn up for all claims

| Place of search | Date of completion of the search | Examiner |
|---|---|---|
| Berlin | 31 August 2010 | Ernst, Monika |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **JOHAN VAN DER TANG et al.** HighFrequency Oscillator Design for Integrated Transceivers. Kluwer Academic Publishers, 84